**Europäisches Patentamt**

**European Patent Office**

**Office européen des brevets**

(11) Veröffentlichungsnummer: **0 154 033**
**A1**

# (12) EUROPÄISCHE PATENTANMELDUNG

(21) Anmeldenummer: **84116226.6**

(22) Anmeldetag: **22.12.84**

(51) Int. Cl.⁴: **G 01 R 31/36**

(30) Priorität: **29.02.84 DE 3407409**

(43) Veröffentlichungstag der Anmeldung:
**11.09.85 Patentblatt 85/37**

(84) Benannte Vertragsstaaten:
**AT BE CH DE FR GB IT LI NL SE**

(71) Anmelder: **ROBERT BOSCH GMBH**
**Postfach 50**
**D-7000 Stuttgart 1(DE)**

(72) Erfinder: **Hollenberger, Horst, Ing**
**Robert-Leicht-Strasse 128**
**D-7000 Stuttgart 80(DE)**

(72) Erfinder: **Meyer-Staufenbiel, Torsten, Ing**
**Brucknerweg 4**
**D-7257 Ditzingen 5(DE)**

(54) **Prüfverfahren für Gleichstromquellen wie Akkumulatoren, Batterien oder dgl. und Prüfgerät.**

(57) Bei einem Prüfverfahren für Gleichstromquellen, wie Akkumulatoren, Batterien od. dgl., wird zur unverfälschten Messung der charakteristischen Daten der zu prüfenden Gleichstromquelle (Prüfling) bei gleichzeitigen geringen Gestehungskosten für ein entsprechendes Prüfgerät der Prüfling hochstrombelastet und nach Beendigung der Hochstrombelastung die Leerlaufspannung ($U_B$) gemessen. Zusätzlich wird der Gleichstrominnenwiderstand ($R_S$) des Prüflings erfaßt und durch Verhältnisbildung dieses Wertes mit dem bekannten Gleichstrominnenwiderstand ($R_{SN}$) einer neuen, vollgeladenen, mit dem Prüfling typgleichen Gleichstromquelle eine Maßzahl für das momentane Startvermögen des Prüflings gewonnen. Mit der Maßzahl für das Startvermögen und dem Bestimmungswert für den Ladezustand des Prüflings wird anhand einer bekannten funktionellen Abhängigkeit des Startvermögens einer mit dem Prüfling typgleichen Gleichstromquelle von ihrem Ladezustand und von ihrem physikalischen Zustand eine Aussage über den physikalischen Zustand des Prüflings gewonnen.

Fig.3

R.  19242
6.2.1984 Rs

ROBERT BOSCH GMBH, 7000 Stuttgart 1

<u>Prüfverfahren für Gleichstromquellen, wie</u>
<u>Akkumulatoren, Batterien od. dgl., und Prüfgerät</u>

Stand der Technik

Die Erfindung betrifft ein Prüfverfahren für Gleichstromquellen, wie Akkumulatoren, Batterien od. dgl.,
der im Oberbegriff des Anspruchs 1 angegebenen Gattung.

Ein solches Prüfverfahren ist aus der DE-AS 29 26 716
bekannt. Hierbei wird zusätzlich der Wechselstrominnenwiderstand des Prüflings bei einer festen Frequenz von
vorzugsweise 100 Hz gemessen und durch Paarung der
gemessenen Werte von Leerlaufspannung und Wechselstrominnenwiderstand mit Hilfe bekannter funktioneller Abhängigkeiten der Leerlaufspannung einerseits und des
Wechselstrominnenwiderstands andererseits jeweils von
dem Ladezustand einer mit dem Prüfling typgleichen
Gleichstromquelle eine Aussage über den physikalischen

0154033
R. 19242

Zustand des Prüflings gewonnen.

Dieses Verfahren bringt allerdings eine richtige Beurteilung des Prüflings nur dann, wenn sich der Prüfling während der Prüfung im Ruhezustand befindet, also alle Ausgleichsvorgänge, die z.B. auftreten nach Anladen mit Werkstattladegeräten oder nach Abnehmen des Prüflings von reichlich dimensionierten Automobilladegeneratoren (Lichtmaschinen), abgeschlossen sind. Da solche Ausgleichsvorgänge oft Stunden benötigen, ist eine zuverlässige Aussage über den Zustand des Prüflings nicht immer gesichert.

Vorteile der Erfindung

Das erfindungsgemäße Prüfverfahren mit den kennzeichnenden Merkmalen des Anspruchs 1 hat demgegenüber den Vorteil, daß durch die kurzzeitige Hochstrombelastung alle Ausgleichsvorgänge im Prüfling mit Beginn der Messung von Leerlaufspannung und Gleichstrominnenwiderstand abgeschlossen sind. Oberflächenladungen z.B., wie sie durch kurzzeitige Schnelladevorgänge entstehen, werden durch diese Hochstrombelastung rückgängig gemacht, und ein Ausgleich zum stabilen Zustand des Prüflings wird durchgeführt. Dadurch ist eine unverfälschte Messung der charakteristischen Daten des Prüflings möglich. Bei Durchführung einer Hochstrombelastung läßt sich in einfacher Weise der Gleichstrominnenwiderstand der Gleichstromquelle messen, ohne daß hierzu ein nennenswerter Mehraufwand wie bei der Erfassung des Wechselstrominnenwiderstands erforderlich ist. Damit ergibt sich bei verbesserter Zuverlässigkeit der Aussage über den Betriebszustand des Prüflings ein verringerter Herstellungsaufwand für das Prüfgerät selbst.

0154033

Das in Anspruch 8 angegebene Prüfgerät zur Durchführung des Prüfverfahrens hat neben dem bereits vorstehend genannten Vorteilen noch den weiteren Vorteil der einfachen Handhabung und Bedienung. Der Prüfende braucht lediglich den Prüfling an das Prüfgerät anzuschließen und einen Prüfvorgang zu starten. Das Prüfergebnis wird ihm an der Anzeigevorrichtung ausgegeben, und zwar einerseits der physikalische Zustand des Prüflings, andererseits der Ladezustand des Prüflings und zum dritten dessen Startvermögen.

Vorteilhafte Ausgestaltungen des erfindungsgemäßen Prüfverfahrens sowie vorteilhafte Ausbildungsformen des dazugehörigen Prüfgeräts ergeben sich aus den weiteren Ansprüchen 2 - 13.

Zeichnung

Die Erfindung ist anhand eines in der Zeichnung dargestelllten Ausführungsbeispiels eines Prüfgeräts zum Durchführen des Prüfverfahrens in der nachfolgenden Beschreibung näher erläutert. Es zeigen:

Fig. 1    ein Blockschaltbild eines Prüfgeräts
          zum Prüfen einer Kraftfahrzeug-Batterie,

Fig. 2    ein Diagramm der Batteriespannung in
          Abhängigkeit von der Zeit vor und
          während des Prüfvorgangs,

Fig. 3    ein Diagramm der funktionellen Abhängigkeit der Leerlaufspannung einerseits und
          des normierten Gleichstrominnenwiderstands andererseits von dem Ladezustand und von dem physikalischen Zustand einer Batterie.

Beschreibung des Ausführungsbeispiels

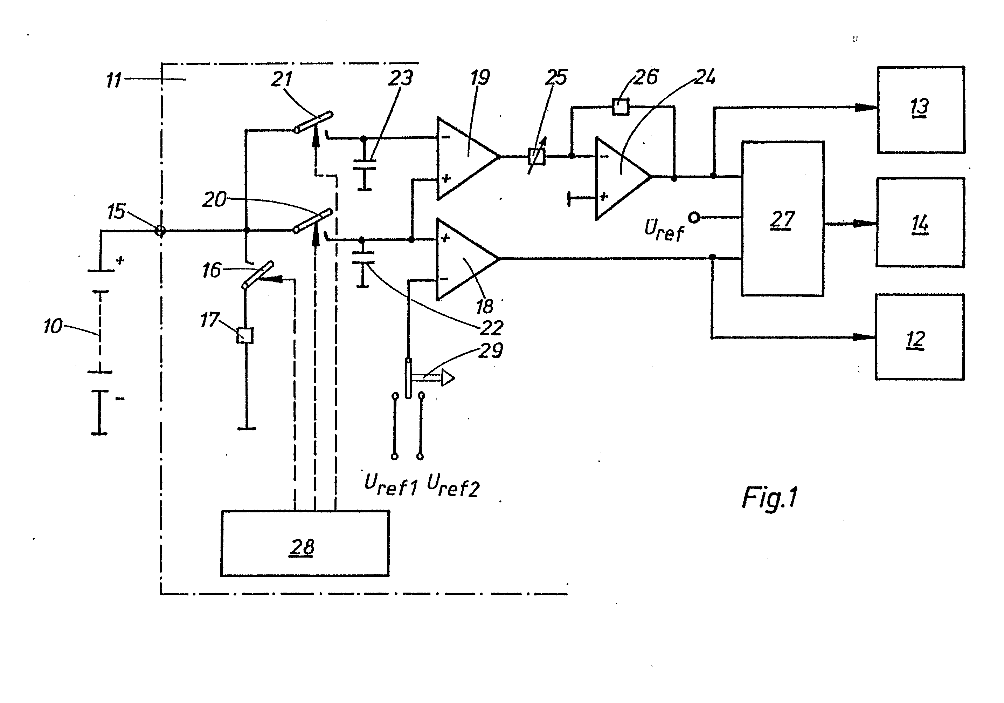

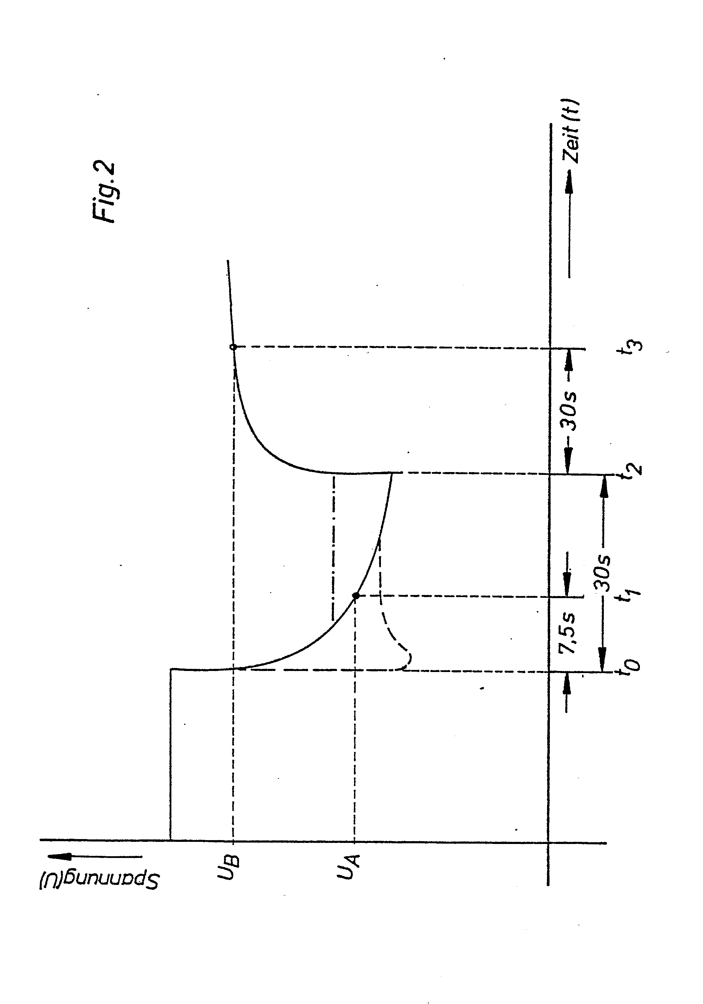

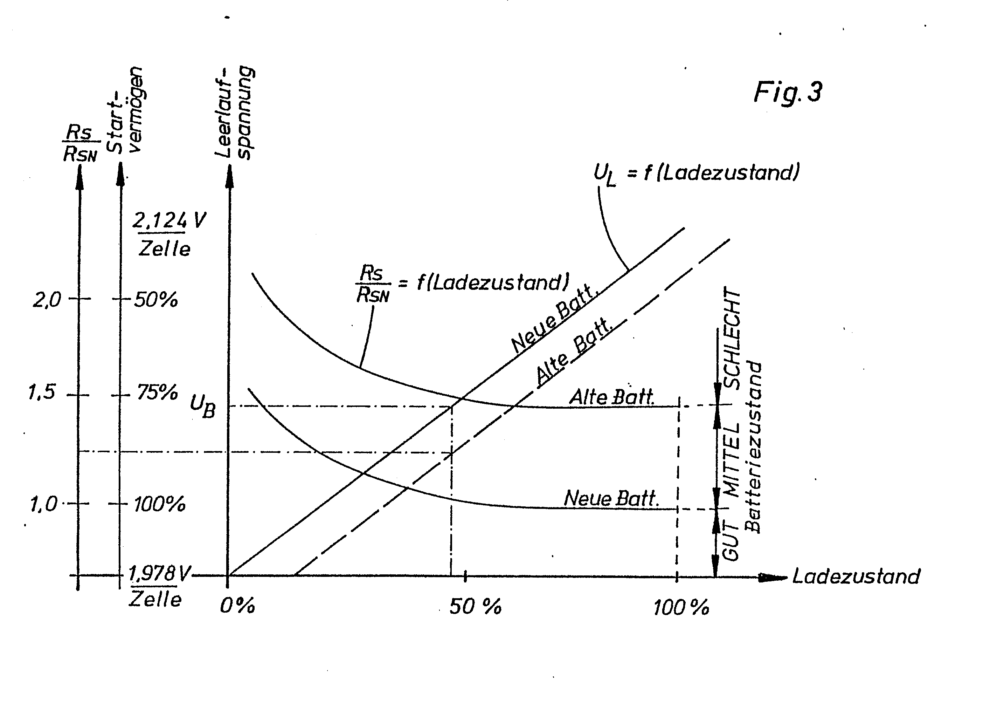

Zunächst wird anhand der Fig. 2 und 3 das Prüfverfahren für Gleichstromquellen, wie Akkumulatoren, Batterien od. dgl., anhand der Prüfung einer Kraftfahrzeug-Batterie (Kfz-Batterie) kurz umrissen, welches dann in der weiteren Beschreibung des Prüfgeräts gemäß Fig. 1 noch näher erläutert wird.

Bei dem Prüfverfahren wird zunächst die zu prüfende Kfz-Batterie, im folgenden Prüfling genannt, zum Zeitpunkt $t_0$ hochstrombelastet. Zum Zeitpunkt $t_2$ wird die Hochstrombelastung beendet. Die Zeitspanne $t_2 - t_0$ der Hochstrombelastung beträgt ca. 30 s. Zu erwartende Spannungsverläufe der Batteriespannung während der Hochstrombelastung sind in Fig. 2 dargestellt. Der ausgezogen dargestellte Spannungsverlauf gilt für den im Beispiel angenommenen Prüfling eines Bleiakkumulators bestimmter Nennkapazität und Kälteprüfstroms. Die gestrichelt bzw. strichpunktiert eingezeichneten Spannungsverläufe gelten für andere Gleichstromquellen.

Zum Zeitpunkt $t_1$, der ungefähr 7,5 s nach Beginn der Hochstrombelastung liegt, wird die Klemmenspannung des Prüflings gemessen. Dieser Meßwert ist in Fig. 2 mit $U_A$ bezeichnet. Zum Zeitpunkt $t_3$, der etwa 30 s nach Beendigung der Hochstrombelastung des Prüflings zum Zeitpunkt $t_2$ liegt, wird die Leerlaufspannung des Prüflings gemessen. Dieser Meßwert ist in Fig. 2 mit

$U_B$ bezeichnet. Die Leerlaufspannung des Prüflings nach der Hochstrombelastung kann – wie Fig. 2 zeigt – niedriger liegen als die Leerlaufspannung des Prüflings vor der Hochstrombelastung. Eine solch höhere Leerlaufspannung kann durch kurzzeitiges Anladen des Prüflings, z.B. mit einem Werkstattladegerät, bewirkt worden sein. Eine solche erhöhte Leerlaufspannung rührt von Oberflächenladungen her, die sich jedoch im Laufe der Zeit durch Ausgleichsvorgänge wieder abbauen. Nach der Hochstrombelastung sind solche Ausgleichsvorgänge abgeschlossen, und der Prüfling befindet sich sozusagen elektrisch gesehen im Ruhezustand.

Mit dem Meßwert $U_B$ der Leerlaufspannung des Prüflings zum Zeitpunkt $t_3$ wird nunmehr der momentane Ladezustand des Prüflings bestimmt. Hierzu benutzt man eine bekannte funktionelle Abhängigkeit der Leerlaufspannung $U_L$ von dem Ladezustand einer mit dem Prüfling typgleichen Gleichstromquelle. Typgleich bedeutet hier, daß die Vergleichs-Gleichstromquelle ebenfalls ein Bleiakkumulator sein und gleiche Nennkapazität aufweisen muß. Die letzte Bedingung kann dann entfallen, wenn die bekannte funktionelle Abhängigkeit normiert ist, z.B. wie in Fig. 3 dargestellt, auf die Zellenspannung bezogen ist, die für Batterien der gleichen Art, z.B. Bleiakkumulatoren, im wesentlichen gleich ist. Eine solche funktionelle Abhängigkeit der Leerlaufspannung vom Ladezustand ist in Fig. 3 dargestellt, und zwar ausgezogen für eine neue Batterie und strichliniert dargestellt für eine gealterte Batterie. Mit dem Meßwert $U_B$, bezogen auf die Anzahl der Batteriezellen, wird nunmehr anhand der funktionellen Verknüpfung von Leerlaufspannung und Ladezustand der Ladezustand des Prüflings bestimmt. Dabei genügt im allgemeinen, wenn man lediglich die funktionelle Abhängigkeit der Leerlaufspannung vom Ladezustand einer neuen Batterie berücksichtigt. Für erhöhte Genauigkeit, was allerdings auch einen vergrößerten Aufwand erfordert, kann man die funktionelle Abhängigkeit einer etwa mit dem Prüfling gleichalten Vergleichsstromquelle benutzen. Der Batterieladezustand, ergibt sich somit also unmittelbar aus dem Meßwert $U_B$ der Leerlaufspannung zum Zeitpunkt $t_3$.

Zusätzlich wird der Gleichstrominnenwiderstand des Prüflings bestimmt. Der augenblickliche Gleichstrominnenwiderstand $R_S$ ermittelt sich aus der Spannungsdifferenz $U_B - U_A$ dividiert durch den Laststrom, der während der Hochstrombelastung des Prüflings geflossen ist. Setzt man den Wert des Gleichstrominnenwiderstands $R_S$ in Beziehung zu dem Gleichstrominnenwiderstand $R_{SN}$ einer neuen, vollgeladenen Batterie mit bestimmter Nennkapazität und bestimmtem Kälteprüfstrom, die typgleich zu dem Prüfling ist, so erhält man den Quotienten als Maßzahl für das momentane Startvermögen des Prüflings. Dieses Startvermögen bzw. der Quotient $R_S/R_{SN}$ ist abhängig von dem Ladezustand und von dem physikalischen Zustand des Prüflings, so daß man umgekehrt bei der bekannten funktionellen Abhängigkeit des Startvermögens einer Gleichstromquelle von ihrem Ladezustand und ihrem physikalischen Zustand eine Aussage über den physikalischen Zustand des Prüflings gewinnen kann. Die funktionelle Abhängigkeit des Startvermögens einer Gleichstromquelle von ihrem Ladezustand und von ihrem physikalischen Zustand ist in Fig. 3 für eine alte Batterie und für eine neue Batterie dargestellt. Mit einer solchen bekannten funktionellen Abhängigkeit einer mit dem Prüfling typgleichen Gleichstromquelle kann nunmehr mit dem bekannten Ladezustand des Prüflings und der bekannten Maßzahl für das momentane Startvermögen des Prüflings festgestellt werden, ob der Schnittpunkt des maßgeblichen Wertepaars unterhalb der Kurve für eine neue Batterie oder oberhalb der Kurve für die alte Batterie oder zwischen beiden Kurven liegt. Im ersten Fall wird der physikalische Zustand des Prüflings mit gut, im zweiten Fall mit schlecht und im dritten mit mittel gewertet.

Mittels des in Fig. 1 im Blockschaltbild zu sehenden Prüfgeräts kann das vorstehend beschriebene Prüfverfahren vollautomatisch durchgeführt werden. Der Prüfende hat lediglich noch den Prüfling 10 an das Prüfgerät 11 anzuschließen, den Prüfvorgang zu starten und das Prüfergebnis an drei getrennten Anzeigen abzulesen, und zwar eine Anzeige 12 für den Ladezustand des Prüflings, eine Anzeige 13 für das momentane Startvermögen des Prüflings und eine Anzeige 14 für den physikalischen Zustand des Prüflings. Ladezustand und Startvermögen des Prüflings werden jeweils in Prozenten angegeben (vergl. Fig. 3).

Das Prüfgerät 11 weist eine Eingangsklemme 15 zum Anschließen des Prüflings 10 auf. An der Eingangsklemme ist über einen ersten Schalter 16 ein Belastungswiderstand 17 angeschlossen. Bei geschlossenem Schalter 16 ist der Prüfling 10 hochstrombelastet, und ein entsprechender hoher Laststrom fließt über den Belastungswiderstand 17. An der Eingangsklemme 15 sind weiter zwei Operationsverstärker 18 und 19, hier einfache Impedanzwandler, angeschlossen, und zwar jeweils über einen Schalter 20 bzw. 21. Dabei ist der nicht invertierende Eingang des ersten Operationsverstärkers 18 über den zweiten Schalter 20 und
der invertierende Eingang des zweiten Operationsverstärkers 19 über den zweiten Schalter 21 mit
der Eingangsklemme 15 verbunden. Der nicht invertierende Eingang des zweiten Operationsverstärkers 19
ist mit dem nicht invertierenden Eingang des ersten
Operationsverstärkers 18 verbunden, und der invertierende Eingang des ersten Operationsverstärkers 18
ist mit einer Referenzspannung $U_{ref}$ belegt. An dem
nicht invertierenden Eingang des ersten Operationsverstärkers 18 und an dem invertierenden Eingang des
zweiten Operationsverstärkers 19 ist jeweils ein
Kondensator 22 bzw. 23 angeschlossen. Dem Ausgang
des zweiten Operationsverstärkers 19 ist ein Umkehrverstärker 24 nachgeschaltet, dessen Vorwiderstand 25
einstellbar ausgebildet ist. Der Widerstand im Gegenkopplungszweig des Umkehrverstärkers 24 ist mit 26
bezeichnet. Der Ausgang des Umkehrverstärkers 24 ist
einerseits mit der Anzeigevorrichtung 13 für das Startvermögen und andererseits mit einer Verknüpfungslogik
27 verbunden. Diese Verknüpfungslogik 27 ist weiterhin
an dem Ausgang des ersten Operationsverstärkers 18
angeschlossen, der zusätzlich unmittelbar mit der
Anzeigevorrichtung 12 für den Ladezustand verbunden
ist. Die Verknüpfungslogik 27, der noch eine Referenzspannung $U_{REF}$ zugeführt ist, verknüpft das Ausgangssignal des ersten Operationsverstärkers 18, das unmittelbar proportional dem Ladezustand des Prüflings
ist, und das Ausgangssignal des Umkehrverstärkers 24,
das unmittelbar proportional dem Startvermögen bzw.
dem normierten Gleichstrominnenwiderstand des Prüflings ist, in der vorstehend beschriebenen Weise miteinander und steuert entsprechend dem Verknüpfungsergeb-

.nis die Anzeigevorrichtung 14 für den physikalischen
Zustand des Prüflings.

Der Ablauf des Prüfvorgangs wird von einer Zeitsteuervorrichtung 28 gesteuert. Die Zeitsteuervorrichtung
28 ist derart ausgebildet, daß sie zeitlich versetzte
Schließsignale unterschiedlicher Dauer selektiv an
die Schalter 16, 20 und 21 gibt, und zwar zu den in Fig.2
bezeichneten Zeitpunkten $t_0$, $t_1$ und $t_3$. Während die
Schließsignale zu den Zeitpunkten $t_1$ und $t_3$ nur ein
kurzzeitiges Schließen der Schalter 20 und 21 zum
Abnehmen des jeweiligen Meßwertes der Spannung des
Prüflings 10 bewirken, dauert das zum Zeitpunkt $t_0$ an den
Schalter 16 gelangende Schließsignal etwa 30 s und
verschwindet zum Zeitpunkt $t_2$.

Das Prüfgerät arbeitet wie folgt:

Nach Anschluß des Prüflings 10 an die Eingangsklemme
15 startet der Prüfende die Zeitsteuervorrichtung 28.
Zum Zeitpunkt $t_0$ wird der Schalter 16 geschlossen und
der Prüfling 10 hochstrombelastet. Zum Zeitpunkt $t_1$
schließt der zweite Schalter 21 und der Kondensator 23
lädt sich auf die zu diesem Zeitpunkt an der Eingangsklemme 15 anliegenden Klemmenspannung $U_A$ auf. Zum Zeitpunkt $t_2$ wird der Schalter 16 wieder geöffnet und damit
die Hochstrombelastung des Prüflings 10 beendet. Zum
Zeitpunkt $t_3$ wird der erste Schalter 20 kurzzeitig geschlossen, so daß sich der Kondensator 22 auf die an
der Eingangsklemme 15 herrschende Klemmenspannung $U_B$
auflädt. Bei richtig eingestellter Referenzspannunf $U_{ref}$
ist die Ausgangsspannung des Operationsverstärkers 18
ein direktes Maß für den Ladezustand des Prüflings, der
in der Anzeigevorrichtung 12 angezeigt wird.

Zum Zeitpunkt $t_3$ liegt am Ausgang des Operationsverstärkers 19 eine Spannung $U_B - U_A$ . Der Vorwiderstand 25 ist so eingestellt, daß er im wesentlichen
gleich dem Gleichstrominnenwiderstand $R_{SN}$ einer mit
dem Prüfling typgleichen Batterie gleicher Nennkapazität und gleichem Kälteprüfstrom ist. Die
Ausgangsspannung des Umkehrverstärkers ist dann
direkt proportional dem Quotienten $R_S/R_{SN}$ bzw. dem
Startvermögen des Prüflings. Diese Spannung wird
der Anzeigevorrichtung 13 für das Startvermögen
zugeführt, und eine entsprechende Prozentanzeige
wird sichtbar.

Die Verknüpfungslogik 27 ist so aufgebaut, daß sie
die Ausgangsspannung des Umkehrverstärkers 24 mit
zwei oder drei verschiedenen Schwellwerten vergleicht, die aus der Referenzspannung $U_{REF}$ abgeleitet
sind. Je nachdem ob die Ausgangsspannung des Umkehrverstärkers 24, die ja dem Startvermögen des Prüflings
entspricht, kleiner oder größer ist als diese Schwellwerte werden in der Anzeigevorrichtung 14 für den
physikalischen Zustand die Anzeigen "gut", "mittel",
"schlecht" sichtbar. Die Schwellen werden in Abhängigkeit vom Ladezustand des Prüflings, also in Abhängigkeit von der Ausgangsspannung des ersten Operationsverstärkers 18, entsprechend den in Fig. 3 angegebenen Funktionen des Startvermögens vom Ladezustand und
vom physikalischen Zustand variiert. Die für
100 % Ladezustand gültigen Schwellen 1,0 (neue Batterie)
und 1,5 (alte Batterie) werden beim Ladezustand von
50 % entsprechend dem Diagramm in Fig. 3 angehoben.

Im allgemeinen ist es ausreichend, wenn die Referenzspannung $U_{ref}$ des ersten Operationsverstärkers 18 so eingestellt ist, daß die Ausgangsspannung des Operationsverstärkers 18 eine Abhängigkeit von der Eingangsspannung aufweist, die der in Fig. 3 ausgezogen dargestellten Funktion der Leerlaufspannung vom Ladezustand für eine neue Batterie entspricht. Da aber auch die Funktion der Leerlaufspannung nicht nur vom Ladezustand sondern auch von dem physikalischen Zustand, sprich Alter, der Batterie abhängt, kann das Prüfverfahren etwas verfeinert werden, wenn auch diese Abhängigkeit der Leerlaufspannung vom Alter der Batterie mit berücksichtigt wird. Hierzu ist ein Handschalter 29 vorgesehen, der entsprechend dem Alter der Batterie umgeschaltet werden muß. In der in Fig. 1 gezeigten Stellung liegt der Handschalter 29 an der Referenzspannung $U_{ref1}$, die für die charakteristische Verknüpfung einer neuen Batterie bestimmend ist. Weiß man, daß der Prüfling bereits relativ alt ist, so ist der Handschalter 29 umzuschalten, so daß er nunmehr an der Referenzspannung $U_{ref2}$ liegt. Die Zusammenhänge von Eingangs- und Ausgangsspannung des Operationsverstärkers 18 entsprechen dann im wesentlichen der in Fig. 3 strichliniert dargestellten Funktion der Leerlaufspannung vom Ladezustand für eine alte Batterie.

R. 19242
6.2.1984  Rs

ROBERT BOSCH GMBH, 7000 Stuttgart 1

Ansprüche

1. Prüfverfahren für Gleichstromquellen, wie Akkumulatoren, Batterien od. dgl., bei welchem man die Leerlaufspannung der zu prüfenden Gleichstromquelle (Prüfling) mißt und daraus den momentanen Ladezustand des Prüflings bestimmt, d a - d u r c h   g e k e n n z e i c h n e t, daß man den Prüfling (10) hochstrombelastet und nach Beendigung der Hochstrombelastung die Messung der Leerlaufspannung ($U_B$) vornimmt, daß man zusätzlich den Gleichstrominnenwiderstand ($R_S$) des Prüflings (10) erfaßt und durch Verhältnisbildung dieses Wertes mit dem bekannten Gleichstrominnenwiderstand ($R_{SN}$) einer neuen, vollgeladenen, mit dem Prüfling typgleichen Gleichstromquelle eine Maßzahl für das momentane Startvermögen des Prüflings (10) gewinnt und daß man mit der Maßzahl für das Startvermögen und dem Bestimmungswert für den Ladezustand des Prüflings (10) anhand einer bekannten funktionellen Abhängigkeit des Startvermögens einer mit dem Prüfling typgleichen Gleichstromquelle von ihrem Ladezustand und von ihrem physikalischen Zustand eine Aussage über den physikalischen Zustand des Prüflings gewinnt.

2. Prüfverfahren nach Anspruch 1, d a d u r c h g e k e n n z e i c h n e t, daß man das momentane Startvermögen, den momentanen Ladezustand und den physikalischen Zustand des Prüflings (10) getrennt anzeigt.

3. Prüfverfahren nach Anspruch 1 oder 2, d a - d u r c h g e k e n n z e i c h n e t, daß man zum Erfassen des Gleichstrominnenwiderstandes ($R_S$) des Prüflings (10) dessen Klemmenspannung ($U_A$) zu einem Zeitpunkt ($t_1$) während der Hochstrombelastung mißt und die Differenz von Leerlauf- und Klemmenspannung ($U_B$, $U_A$) bildet.

4. Prüfverfahren nach Anspruch 3, d a d u r c h g e k e n n z e i c h n e t, daß man die Messung der Klemmenspannung ($U_A$) etwa 7,5 s nach Beginn der Hochstrombelastung des Prüflings (10) und die Messung der Leerlaufspannung ($U_B$) etwa 30 s nach Ende der Hochstrombelastung durchführt.

5. Prüfverfahren nach einem der Ansprüche 1 - 4, d a d u r c h g e k e n n z e i c h n e t, daß man die Dauer der Hochstrombelastung des Prüflings (10) etwa 30 s bemißt.

6. Prüfverfahren nach einem der Ansprüche 1 - 5, d a d u r c h   g e k e n n z e i c h n e t, daß man den Bestimmungswert für den momentanen Ladezustand des Prüflings (10) aus dem Meßwert der Leerlaufspannung ($U_B$) gemäß einer bekannten funktionellen Abhängigkeit der Leerlaufspannung einer mit dem Prüfling typgleichen Gleichstromquelle von ihrem Ladezustand gewinnt.

7. Prüfverfahren nach einem der Ansprüche 1 - 5, d a d u r c h   g e k e n n z e i c h n e t, daß man den Bestimmungswert für den momentanen Ladezustand des Prüflings (10) aus dem Meßwert ($U_B$) der Leerlaufspannung gemäß einer bekannten funktionellen Abhängigkeit der Leerlaufspannung einer mit dem Prüfling typgleichen Gleichstromquelle von ihrem Ladezustand und ihrem physikalischen Zustand gewinnt.

8. Prüfgerät zur Durchführung des Prüfverfahrens nach einem der Ansprüche 1 - 7, g e k e n n z e i c h n e t   d u r c h   mindestens eine Eingangsklemme (15) zum Anschließen des Prüflings (10), einen über einen ersten Schalter (16) mit der Eingangsklemme (15) verbundenen Belastungswiderstand (17) zur Hochstrombelastung des Prüflings (10), einen ersten Operationsverstärker (18), dessen nicht invertierender Eingang über einen zweiten Schalter (20) an der Eingangsklemme (15) angeschlossen ist, einen zweiten Operationsverstärker (19), dessen invertierender Eingang über einen dritten Schalter (21) mit der Eingangsklemme (15) und dessen nicht invertierender Eingang mit dem gleichartigen Eingang des ersten Operationsverstärkers (18) verbunden ist, einen dem zweiten Operationsverstärker (19) nachgeschalteten Umkehrverstärker (24) mit vorzugsweise einstellbarem Vorwiderstand (25) und eine mit dem ersten Operationsverstärker (18) und dem Umkehrverstärker (24) verbundene Verknüpfungslogik (27), die eine Anzeigevorrichtung (14) für den physikalischen Zustand des Prüflings (10) steuert.

9. Prüfgerät nach Anspruch 8, g e k e n n z e i c h - n e t d u r c h einen mit den Steuereingängen der Schalter (16,20,21) verbundene Zeitsteuervorrichtung (28), die derart ausgebildet ist, daß sie zeitlich versetzte Schließsignale unterschiedlicher Dauer selektiv an die Schalter (16, 20,21) in der Weise gibt, daß der erste Schalter (16) für ca. 30 s geschlossen ist und daß der dritte Schalter (21) ca. 7,5 s nach Schließen des ersten Schalters (16) und der zweite Schalter (20) ca. 30 s nach Wiederöffnen des ersten Schalters (16) jeweils kurzzeitig geschlossen sind.

10. Prüfgerät nach Anspruch 8 oder 9, d a d u r c h g e k e n n z e i c h n e t, daß den mit der Eingangsklemme (15) verbundenen Eingängen der beiden Operationsverstärker (18,19) jeweils ein Speicherglied, vorzugsweise ein Kondensator (22,23), parallel geschaltet ist.

11. Prüfgerät nach einem der Ansprüche 8 - 10, d a d u r c h g e k e n n z e i c h n e t, daß an dem Ausgang des ersten Operationsverstärkers (18) eine Anzeigevorrichtung (12) für den Ladezustand und an dem Ausgang des Umkehrverstärkers (24) eine Anzeigevorrichtung (13) für das Startvermögen des Prüflings (10) angeschlossen
ist.

12. Prüfgerät nach einem der Ansprüche 8 - 11,
d a d u r c h   g e k e n n z e i c h n e t,
daß der invertierende Eingang des ersten
Operationsverstärkers (18) mit einer Referenzspannung belegt ist, die vorzugsweise mittels eines
Wahlschalters (29) änderbar ist.

−.−.−.−.−.−.−.−

Fig.1

13  14  12

27

26  24

$U_{ref}$

25

19  18  22  29

23

21  20  16  17

$U_{ref1}$  $U_{ref2}$

28

11

15

10

Fig.2

Fig. 3

**0154033**

Nummer der Anmeldung

EP 84 11 6226

Europäisches
Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-B-2 610 536 (SIEMENS AG) <br> * Anspruch 1 * | 1,6,7 | G 01 R 31/36 |
| A | | 3-5 | |
| Y | PATENT ABSTRACTS OF JAPAN, Band 5, Nr. 191, 5. Dezember 1981, Seite (P-92) (863); & JP-A-56-117176 (JIBOSHA KOGAI) 14-09-1981 <br> * Zusammenfassung * | 1,6-8 | |
| Y | US-A-4 423 379 (W.R. JACOBS et al.) <br> * Ansprüche 1,8,19; Figuren 1,7,9,12 * | 6-8 | |
| A | IEEE TRANSACTIONS ON INSTRUMENTATION AND MEASUREMENT, Band IM-31, Nr. 3, September 1982, New York, USA; E. OFRY et al. "Measurement of the State of Battery Charge using an Improved Loaded Voltmeter Test Method", Seiten 154-158 <br> * Seiten 154-158 * | | RECHERCHIERTE SACHGEBIETE (Int. Cl.4) <br><br> G 01 R 31/36 |

Der vorliegende Recherchenbericht wurde für alle Patentansprüche erstellt.

| Recherchenort <br> BERLIN | Abschlußdatum der Recherche <br> 29-05-1985 | Prüfer <br> LEMMERICH J |
|---|---|---|